# EUROPEAN PATENT SPECIFICATION

(11) **EP 2 754 139 B1**
(45) Date of publication and mention of the grant of the patent: **03.02.2016**
(21) Application number: 12753381.8
(22) Date of filing: 29.08.2012
(51) Int. Cl.: G01R 31/36, G08B 29/18, H04B 17/00, H04W 52/02

(54) **METHOD AND DEVICES FOR MONITORING A BATTERY OF A MOBILE COMMUNICATION DEVICE**
VERFAHREN UND VORRICHTUNGEN ZUR ÜBERWACHUNG DER BATTERIE EINER MOBILKOMMUNIKATIONSVORRICHTUNG
PROCÉDÉ ET DISPOSITIFS DE SURVEILLANCE D'UNE BATTERIE D'UN DISPOSITIF DE COMMUNICATION MOBILE

(30) Priority: 08.09.2011 CH 14852011
(43) Date of publication of application: 16.07.2014
(73) Proprietor: Limmex AG, 8048 Zürich (CH)
(72) Inventor: RITTER, Moritz, CH-8703 Erlenbach (CH); KÖNIG, Pascal, CH-8006 Zürich (CH)
(74) Representative: Rentsch Partner AG
(86) International application number: PCT/CH2012/000206
(87) International publication number: WO 2013/033854

(56) References cited:
- WO-A1-2009/109642
- US-A- 4 647 914
- US-A- 5 673 304

## Description

### Field of the Invention

The present invention relates to a method and devices for monitoring a battery included in a mobile communication device. Specifically, the present invention relates to a method, a computerized service unit, and a mobile communication device for monitoring the battery included in the mobile communication device, particularly a mobile personal security or emergency call device.

### Background of the Invention

In a personal security or emergency call system, a personal security or emergency call device is used to trigger an alarm. The personal emergency call device executes an emergency call on behalf of its user and communicates with a computerized emergency service platform. The emergency service platform initiates actions for providing support to the person in need.

WO 2009/109642 describes a personal security or emergency call device having an element for triggering an emergency call via mobile radio communication. According to WO 2009/109642, the personal security or emergency call device checks the charge level of its battery periodically and/or after an emergency call. In case of a low battery, the device issues automatically a local acoustic alarm message and/or informs an external site. According to WO 2009/109642, an emergency call center forwards the emergency call to defined telephone numbers.

Generally, mobile communication devices must either be recharged frequently or require a base station for communication. It is preferable that personal security or emergency call devices are not limited to the range of a base station for communication. Nevertheless, they should be easy to use and always ready for reliable operation. While a combination of increased stand-by time and local battery monitoring provide for improved battery and power management, recharge cycle times are typically shortened because, in an attempt to obtain high reliability, local battery monitoring typically results in more frequent recharging.

### Summary of the Invention

It is an object of this invention to provide a method and devices for monitoring a battery included in a mobile communication device, which method and devices do not have at least some of the disadvantages of the prior art.

According to the present invention, these objects are achieved through the features of the independent claims. In addition, further advantageous embodiments follow from the dependent claims and the description.

According to the present invention, the above-mentioned objects are particularly achieved in that for monitoring a battery status of a battery included in a mobile communication device, received are in a computerized service unit, via a mobile radio network, battery status reports from the mobile communication device. The battery status reports include at least an electrical battery parameter indicative of a current charge or voltage level of the battery. In the computerized service unit, stored are battery data, based on the battery status reports received from the mobile communication device. The battery data includes at least a time series of the electrical battery parameter.

In an embodiment, received are in the computerized service unit battery related event information included in the battery status reports from the mobile communication device. The battery related event information includes the time when the battery was installed, the time when battery recharging started, the time when-battery recharging completed, the time when the stand by mode was turned on, and/or the time when the stand by mode was turned off. In the computerized service unit, stored is battery data including the battery related event information.

In a further embodiment, received is in the computerized service unit ambient temperature information associated with the battery and included in the battery status reports from the mobile communication device. In the computerized service unit, stored is battery data which includes the ambient temperature information associated with the battery.

In another embodiment, using the battery data, an expected value of a battery parameter is determined in the computerized service unit. Determined is a deviation of a battery parameter, included in the battery status report, from the expected value of the battery parameter. For cases where the deviation exceeds a defined deviation threshold, a battery alarm signal is transmitted from the computerized service unit to one or more recipients, assigned in the computerized service unit to the mobile communication device.

In yet another embodiment, using the battery data, determined is in the computerized service unit an average recharging cycle time at the mobile communication device. For cases where the average recharging cycle time deviates from an expected value of the recharging cycle time, a battery alarm signal is generated in the computerized service unit.

In a further embodiment, using the battery data, determined is in the computerized service unit a threshold level for triggering in the mobile communication device a low battery warning signal. The threshold level is transmitted from the computerized service unit to the mobile communication device.

In another embodiment, a low battery warning signal is received in the computerized service unit from the mobile communication device. For cases where the battery is not recharged or replaced (installed) at the mobile communication device within a defined time limit after the low battery warning signal, a battery recharging alarm is generated in the computerized service unit.

According to the present invention, the above-mentioned objects are further achieved in that a computerized service unit comprises a communication module configured to receive via a mobile radio network periodic battery status reports from a mobile communication device. The battery status reports include at least an electrical battery parameter indicative of a current charge or voltage level of the battery. The computerized service unit further comprises a battery analyzer configured to store in the computerized service unit battery data, based on the battery status reports received from the mobile communication device, the battery data including at least a time series of the electrical battery parameter.

In an embodiment, the battery analyzer is further configured to store in the computerized service unit battery data including battery related event information received in the battery status reports from the mobile communication device The battery related event information includes the time when the battery was installed, the-time when battery recharging started, the time when battery recharging completed, the time when the stand by mode was turned on, and/or the time when the stand by mode was turned off.

In a further embodiment, the battery analyzer is configured to store in the computerized service unit battery data including ambient temperature information associated with the battery and received in the battery status reports from the mobile communication device.

In another embodiment, the battery analyzer is configured to determine, using the battery data, an expected value of a battery parameter, to determine a deviation of a battery parameter, included in the battery status report, from the expected value of the battery parameter, and to transmit a battery alarm signal to one or more recipients, assigned in the computerized service unit to the mobile communication device, for cases where the deviation exceeds a defined deviation threshold.

In yet another embodiment, the battery analyzer is further configured to determine, using the battery data, an average recharging cycle time at the mobile communication device, and to generate a battery alarm signal, for cases where the average recharging cycle time deviates from an expected value of the recharging cycle time.

In a further embodiment, the battery analyzer is further configured to determine, using the battery data, a threshold level for triggering in the mobile communication device a low battery warning signal, and to transmit the threshold level to the mobile communication device.

In another embodiment, the battery analyzer is further configured to generate a battery recharging alarm, for cases where the battery is not recharged or replaced (installed) at the mobile communication device within a defined time limit after a low battery warning signal has been received in the computerized service from the mobile communication device.

A battery powered mobile communication device comprises a battery monitoring system configured to monitor a battery status of the battery, the battery status including at least an electrical battery parameter indicative of a current charge or voltage level of the battery.

According to the present invention, the above-mentioned objects are further achieved in that the battery monitoring system is further configured to generate and transmit battery status reports via a mobile radio network to a computerized central service unit, the battery status reports including at least the electrical battery parameter, for generating and storing at the computerized central service unit battery data including at least a time series of the electrical battery parameter.

In an embodiment, the battery monitoring system is further configured to transmit to the computerized service unit battery related event information included in the battery status reports, the battery related event information including the time when the battery was installed, the time when battery recharging started, the time when battery recharging completed, the time when the stand by mode was turned on, and/or the time when the stand by mode was turned off, for storing in the computerized service unit battery data including the battery related event information.

In a further embodiment, the battery monitoring system is further configured to measure and transmit to the computerized service unit ambient temperature information associated with the battery and included in the battery status reports, for storing in the computerized service unit battery data including the ambient temperature information associated with the battery.

In an embodiment, the mobile communication device is a personal emergency call device, comprising an alarm module configured to transmit to the computerized central service unit, via a mobile radio network, an alarm message on behalf of a user of the personal emergency call device.

The mobile communication device or personal mobile emergency call device, respectively, and the computerized service unit form a system for monitoring a battery status of a battery included in a mobile communication device.

In addition to the mobile communication device or personal mobile emergency call device, the computerized service unit, and a method for monitoring a battery status of a battery included in a mobile communication device, the present invention also relates to computer program products comprising computer readable media having stored therein computer program code for directing the mobile communication device or personal mobile emergency call device and/or the computerized service unit.

### Brief Description of the Drawings

The present invention will be explained in more detail, by way of example, with reference to the drawings in which:
- Figure 1:: shows a block diagram illustrating schematically a system comprising a mobile communication device, configured as a personal mobile emergency call device, and a computerized service unit which are interconnected via a mobile radio network.
- Figure 2:: shows a flow diagram illustrating an exemplary sequence of steps for identifying the caller of an emergency call, received via a mobile radio network, from a personal mobile emergency call device.
- Figure 3:: shows a flow diagram illustrating an exemplary sequence of steps for monitoring the battery status of a battery included in a mobile communication device.

### Detailed Description of the Preferred Embodiments

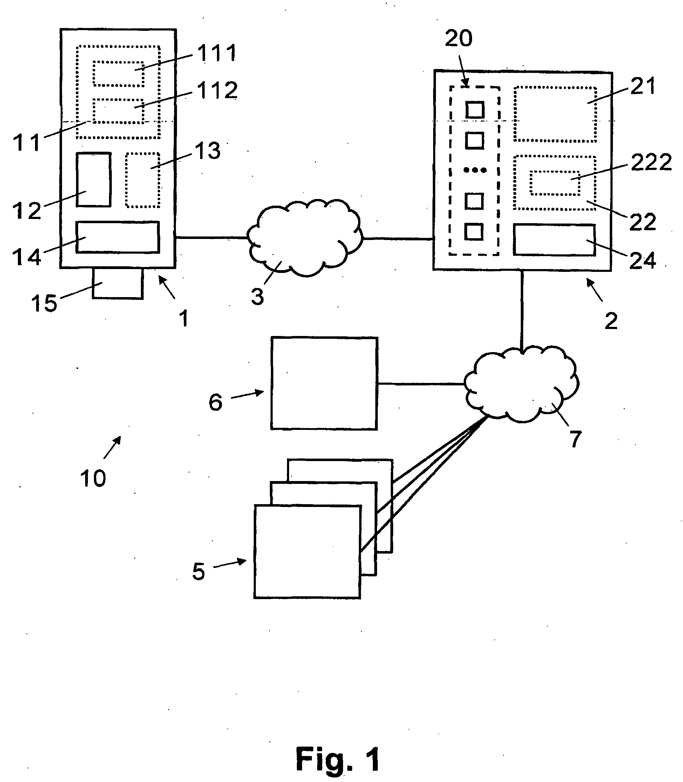

In Figures 1-3, reference numeral 1 refers to a mobile communication device, reference numeral 2 refers to a computerized central service unit 2, and reference numeral 5 refers to other communication terminals or communication partners, respectively.

The mobile communication device 1 comprises a communication module 14 configured for data and voice communication via a mobile radio network 3, e.g. a GSM-network (Global System for Mobile communications), a UMTS-network (Universal Mobile Telephone System), or another terrestrial or satellite-based mobile radio telephone system. The mobile communication device 1 comprises a subscriber identity module (SIM) 15 which has stored therein a subscriber identity for personalizing the mobile communication device 1. For example, the subscriber identity is an International Mobile Subscriber Identity (IMSI) for registering and identifying the user of the mobile communication device 1 as a subscriber of the mobile radio network 3. The mobile communication device 1 further comprises a rechargeable battery 12, accumulator, or other energy store for electrically powering the mobile communication device 1.

As illustrated schematically in Figure 1, the mobile communication device 1 comprises further functional modules, specifically, an alarm module 11 and/or a battery monitoring system 13. As will be described below in more detail, the alarm module 11 is configured to establish via the mobile radio network 3 a connection for an emergency call to the computerized central service unit 2. The battery monitoring system 13 is configured to monitor the battery 12 and transmit via the mobile radio network 3 battery status reports to the computerized central service unit 2. In the configuration with the alarm module 11, the battery powered mobile communication device 1 constitutes a personal mobile emergency call device 1 which is preferably implemented as a wearable device, such as a wrist watch or a bracelet, or as another portable device for triggering a personal alarm via the mobile radio network 3, such as a mobile phone or another mobile communication terminal. For voice communication via an established (emergency) call, the mobile communication device or personal emergency call device 1, respectively, may include a speaker and a microphone. As indicated by reference numeral 10, the personal emergency call device 1 and the central service unit 2 make up a personal emergency call system. The battery monitoring system 13 is particularly useful as part of the personal mobile emergency call device 1; nevertheless, as one skilled in the art will understand, the battery monitoring system 13 also operates in battery powered mobile communication devices 1 which are not provided with an alarm module 11.

In connection with the alarm module 11, the mobile communication devices 1 comprises an alarm trigger 111 and a personal emergency call device identifier 112 which is stored in the mobile communication device or personal emergency call device 1, respectively. The alarm trigger 111 is an operating element such as a button, a switch, a key, a pressure, inductive, capacitive, optical or resistive sensor, or another means enabling the user to trigger manually a personal alarm. In an embodiment, the alarm trigger 111 is configured to trigger a personal alarm automatically depending on defined alarm conditions on defined data or parameter values measured at the mobile communication device or personal emergency call device 1, respectively, e.g. using acceleration, altitude, motion, heart rate, pulse frequency, blood pressure, body temperature, and/or oxygen saturation sensors. The personal emergency call device identifier 11 2 is a unique alphanumeric code for identifying non-ambiguously the personal emergency call device 1 and its user at the central service unit 2. Accordingly, the personal emergency call device identifier 11 2 is stored at the central service unit 2 assigned to the user who is defined by personal data, such as name, address, identification number(s), birth date, etc., or device-specific data such as shift number, area of use, etc. in case of use in professional organizations.

The central service unit 2 comprises one or more operational computers including one or more processors connected to program and data memory. The central service unit 2 comprises a communication module 24 configured to communicate via the mobile radio network 3 with a plurality of mobile communication devices or personal emergency call devices 1, respectively. The communication module 24 is further configured to communicate via telecommunications network 7 with other communication terminals or communication partners 5. In addition, the communication module 24 makes it possible to access the central service unit 2 through the telecommunications network 7 via a web interface 6. The telecommunications network 7 comprises fixed and/or mobile networks and the Internet. The web interface 6 is configured to enable the user to define in the central service unit 2 emergency contact numbers, emergency actions, emergency processing, and other settings for his/her personal emergency call devices 1.

As illustrated schematically in Figure 1, the central service unit 2 comprises further functional modules, specifically, an alarm processor 21 and/or a battery analyzer 22. The alarm processor 21 is configured to receive and process emergency calls from the personal emergency call device 1. The battery analyzer 22 is configured to receive battery status reports from the mobile communication device or personal emergency call device 1, respectively, and to store and analyze respective battery data 222. In an embodiment, the central service unit 2 comprises a plurality of dial-in nodes 20 making it possible to receive emergency calls addressed to different called numbers assigned in each case to the dial-in nodes 20.

Preferably, the functional modules are implemented as programmed software modules comprising computer program code for directing the processors of the central service unit 2 or the mobile communication device or personal emergency call device 1, respectively. One skilled in the art will understand, however, that in alternative embodiments, the functional modules may be implemented fully or partly by way of hardware components.

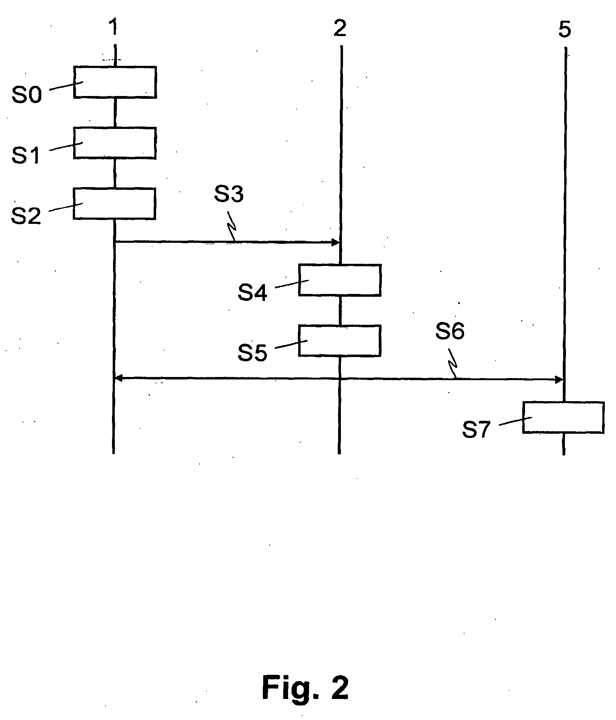

In the following paragraphs, described with reference to Figure 2 are possible sequences of steps performed by the functional modules for identifying at the central service unit 2 the caller of an emergency call received via the mobile radio network 3 from the personal mobile emergency call device 1.

In preparatory step S0, the personal mobile emergency call device 1 is activated and registered with the mobile radio network 3. Accordingly, the mobile subscriber identity is registered with a Home Location Register (HLR) of the mobile radio network 3.

In step S1, responsive to user actions and/or current values of user parameters, the alarm trigger 111 triggers a personal alarm.

In step S2, responsive to the alarm trigger 111, the alarm module 11 executes an emergency call to the central service unit 2. Depending on the embodiment and/or configuration of the personal mobile emergency call device 1, the emergency call includes the establishment of a voice connection, for an emergency telephone call, or simply the transmission of an emergency call message. In addition, depending on the embodiment, the initiation of an emergency call includes generating one or more accompanying alarm messages assigned to the emergency call. The accompanying alarm messages include in each case the personal emergency call device identifier 112 and an alarm identification number. For example, the alarm identification number includes a sequential alarm number generated by the alarm module 11, e.g. in combination with a current date and time value. In the emergency call, the alarm identification number is transmitted over the voice channel and encoded as tones, preferably including redundant information for forward error correction. For example, the alarm identification number is encoded as Dual-tone multi-frequency (DTMF) or modem tones, e.g. according to ITU-T (International Telecommunication Union Telecommunication Standardization Sector) recommendations V.90/V.92. In an embodiment, the emergency call and/or the accompanying alarm messages include geographical location information, e.g. the current location of the personal mobile emergency call device 1 determined by way of a GPS receiver in the device 1 or from base station identifiers or other network information provided by the mobile radio network 3.

In step S3, the connection for the emergency call is set up with the central service unit 2, and, if applicable, the accompanying alarm messages are transmitted via the mobile radio network 3 to the central service unit 2.

If the central service unit 2 is provided with different dial-in nodes 20, the emergency call is addressed to the dial-in node assigned to the personal mobile emergency call device 1 or its telephone number (e.g. its MSISDN), respectively. The assignment of dial-in nodes to different telephone numbers depends on one or more defined digits of the telephone numbers, e.g. one or more leading and/or trailing digits. For example, the last two digits of the MSISDN assigned to the personal mobile emergency call device 1 define a specific one of the dial-in nodes 20 of the central service unit 2.

Depending on embodiment and/or configuration of the device 11, the accompanying alarm messages are transmitted redundantly to the central service unit 2 via different communication channels, e.g. over the voice channel of the mobile radio network 3, via a packet oriented data channel of the mobile radio network 3 such as GPRS (General Packet Radio Service), through a signalling channel of the mobile radio network 3, via a Short Messaging Service (SMS) of the mobile radio network 3 as an SMS message, and/or via Unstructured Supplementary Service Data (USSD) as an USSD message of the mobile radio network 3. For transmitting the personal emergency call device identifier 112 or the accompanying alarm message, respectively, via the voice channel to the central service unit 2, the personal emergency call device identifier 112 or the accompanying alarm message is encoded as tones, e.g. as outlined above in the context of the alarm identification number, and includes redundant information for forward error correction.

In step S4, the alarm processor 21 receives the emergency call on behalf of the user of the personal mobile emergency call device 1 and performs an identification process for determining the identity of the calling user or its device 1, respectively. Depending on the embodiment and/or emergency configurations for the personal mobile emergency call device 1 in the central service unit 2, the identification process uses the caller ID, provided by the mobile radio network 3 for the registered subscriber, and the personal emergency call device identifier 112, received in the emergency call via the voice channel or in one or more separate accompanying alarm messages. If the central service unit 2 is provided with multiple dial in nodes 20, one or more defined digits of the caller ID are determined - or verified - based on the dial-in node over which the emergency call was received, e.g. a first dial-in node defines the last two digits as "00", a second dial in-node defines the last two digits as "01" etc. Preferably, however, the identification process relies on the personal emergency call device identifier 112 received with the emergency call and/or in separate accompanying alarm messages. If the personal emergency call device identifier 112 is received in a separate accompanying alarm message, it is assigned to the emergency call based on the alarm identification number transmitted with the emergency call and included in the respective accompanying alarm message.

In step 55, for further processing of the emergency call, the alarm processor 21 retrieves from a local database of the central service unit 2 emergency contact numbers, emergency actions, and emergency processing steps defined for the determined personal mobile emergency call device 1 or its user, respectively.

In step S6, according to the defined emergency processing, the alarm processor 21 performs any defined processing steps, and establishes emergency call connections and/or transmits emergence messages on behalf of the user with and to various emergency contacts 5 via the telecommunications network 7.

In step S7, the emergency contacts 5 will initiate and perform any emergency actions for the user. Emergency actions include, for example, setting up a voice connection with the personal mobile emergency call device 1.

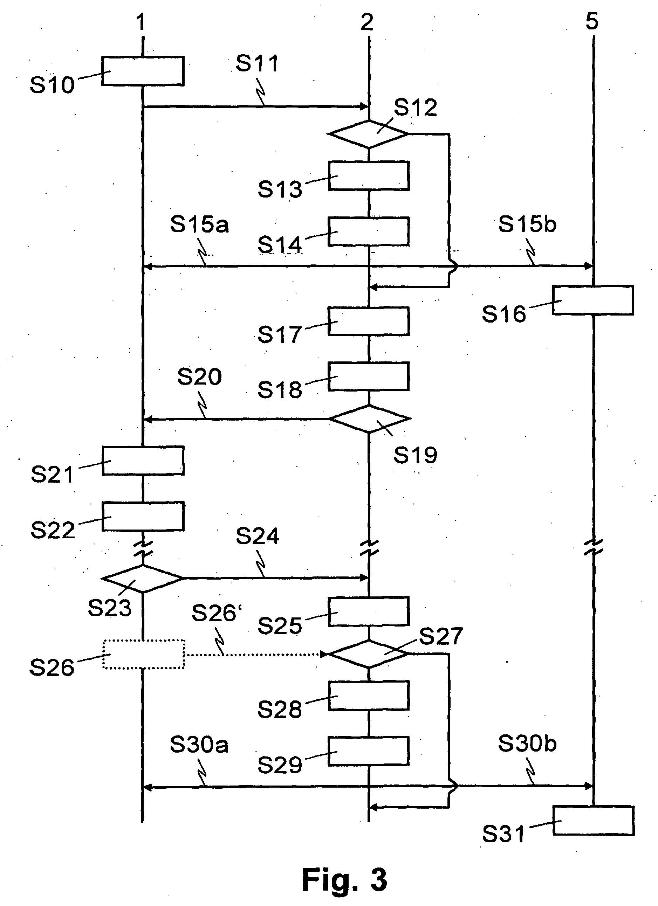

In the following paragraphs, described with reference to Figure 3 are possible sequences of steps performed by the functional modules for monitoring the battery status of the battery 1 2 of the mobile communication device or personal emergency call device 1, respectively. For better clarity, in the following paragraphs, the mobile communication device or personal mobile emergency call device 1, respectively, are simply referred to as device 1.

In step S10, the battery monitoring system 13 of the device 1 generates a battery status report regarding the current status of the battery 12. For example, battery status reports are generated periodically and/or triggered by defined events such as an emergency call or low battery alarm, start and end of recharging the battery 12, replacing the battery 12, entering and leaving a stand by mode of the device 1, or timeouts defined by the central service unit 2.

Accordingly, a battery status report includes current values of battery parameters and, depending on the situation or embodiment, event-specific information such as the time when recharging of the battery 1 2 started, the time when recharging of the battery 12 was completed or ended, the time when the battery 12 was installed, the time when a stand-by mode of the device 1 was turned on, and the time when the stand by mode was turned off. Battery parameters include an electrical battery parameter which indicates the current charge or voltage level of the battery 12, e.g. a voltage value, and ambient temperature values, e.g. the actual temperature of the battery 12 or of other electrical components of the device 1, e.g. a processor temperature.

Furthermore, the battery status reports include in each case a time stamp with an indication of current date and time and preferably a device identifier, e.g. the personal emergency call device identifier 112 described above.

In step S11, the battery status report is transmitted via the mobile radio network 3 to the central service unit 2. For example, the battery status report is transmitted via various redundant communication channels, as described above in the context of accompanying alarm messages associated with an emergency call.

In step S12, the battery analyzer 22 of the computerized service unit 2 receives the status report and determines whether the status report indicates a deviation from expected battery data. A deviation is indicated, for example, by a difference of a battery parameter, included in the battery status report, from the value of this parameter, expected at the particular time indicated in the battery status report, e.g. a difference in voltage or temperature values for the respective point in time. Another example is a deviation of the average length of the battery recharging cycle, as defined by one or more battery status reports, from an expected length of the recharging cycle at the respective point in time. In case of a deviation exceeding a defined threshold value, processing continues in step S13; otherwise, in step S17.

In step S13, the battery analyzer 22 generates an alarm or warning message for the determined and identified deviation. For example, the voltage or charge level of the battery 12 decreases far more rapidly than expected or the recharging cycle is significantly shorter than expected.

In step S14, the battery analyzer 22 determines in a local database of the central service unit 2 emergency contact information, e.g. telephone numbers, e-mail addresses, etc., of parties associated with the device 1 that need to be notified about the respective deviation.

In steps S15a, S15b, the alarm or warning message are transmitted via the mobile radio network 3 or the telecommunications network 7, to the device 1 and identified emergency contacts 5.

In step S16, the emergency contacts, 5 will initiate and perform any responsive actions for the device 1 or its user, respectively.

In step S17, the battery analyzer 22 stores in the central service unit 2 battery data 222 including the battery parameters received with the battery status report. Specifically, the battery analyzer 22 stores a time series of the electrical battery parameter. Depending on the embodiment, the battery analyzer 22 further stores in the time series event-related information received with the battery status report. In addition, the battery analyzer 22 derives and stores further battery data from the received battery status report. In an embodiment, rather than relying on event-related information from the device 1, the battery analyzer 22 derives event information from the received battery status reports and stores the derived information at the central service unit 2. For example, the battery analyzer 22 determines from an increase in the reported value of the electrical battery parameter that the battery 12 is being recharged at the device 1, e.g. based on a gradual increase of the reported voltage level, or that the battery 12 was installed (e.g. replaced) at the device 1, e.g. based on an abrupt and significant increase (jump) of the reported voltage level.

In step S18, the battery analyzer 22 determines from the stored battery data expected values for various battery parameters. Specifically, the battery analyzer 22 determines from the time series and recorded communication activity, e.g. the number of alarms transmitted, the time in stand-by and non-stand-by mode, as well as from the age and type of the battery 12, the expected value of the electrical battery parameter and also the expected average recharge cycle time. Furthermore, the battery analyzer 22 determines from the current values of the electrical battery parameter and the ambient temperature the threshold value for determining a low battery level. Typical use patterns of a specific client or larger client groups can be used to determine this threshold value. Preferably, a safety margin is included in this calculation in order to continuously provide enough battery capacity in case of an emergency.

In step S19, the battery analyzer 22 determines whether the determined (e.g. temperature-dependent) threshold values have changed for the respective device 1. If applicable, in step S20, new threshold values are transmitted via the mobile radio network 3 to the device 1, where they are stored in step S21.

In step S22, the battery monitoring module 13 receives and stores the new threshold values in the device 1.

In step S23, the battery monitoring module 13 measures the current values of battery parameters, specifically the electrical battery parameter indicating the current charge or voltage level of the battery 12. Moreover, the battery monitoring module 13 compares the current value of the electrical battery parameter to the stored threshold value for determining a low battery level.

If the current value of the electrical battery parameter is below the stored threshold value, in step S24, the battery monitoring module 13 generates and transmits via the mobile radio network 3 a low battery alarm message to the central service unit 2.

In step S25, the battery analyzer 22 receives and stores in the time series associated with the battery 12 the low battery alarm. Furthermore, the battery analyzer 22 starts a timer for measuring the length of time expired from the time when the low battery alarm was generated (time stamp).

In step S27, the battery analyzer 22 determines whether, within a defined time interval after the low battery alarm, a battery status report is received in steps S26, S26' that indicates that the battery 12 has been replaced (installed) or is being recharged, either by way of a battery change event, a battery recharge event, or an increase of the value of the electrical battery parameter, as described above. If such an indication is not received at the central service unit 2, within the defined time window, processing continues in step S28; otherwise steps S28, S29 are omitted.

In step S28, the battery analyzer 22 generates an alarm for a low battery at the device 1 which is not being recharged or replaced (installed).

In step S29, the battery analyzer 22 determines in the local database of the central service unit 2 emergency contact information of parties associated with the device 1 that need to be notified about the low battery.

In steps S30a, S30b, the low battery alarm message is transmitted via the mobile radio network 3 or the telecommunications network 7, to the device 1 and identified emergency contacts 5.

In step S31, the emergency contacts 5 will initiate and perform any responsive actions for the device 1 or its user, respectively.

It should be noted that, in the description, the computer program code has been associated with specific functional modules and the sequence of the steps has been presented in a specific order, one skilled in the art will understand, however, that the computer program code may be structured differently and that the order of at least some of the steps could be altered, without deviating from the scope of the invention.

## Claims

1. A method of monitoring a battery status of a battery (12) included in a mobile communication device (1), the method comprising:
receiving (S12) in a computerized service unit (2) via a mobile radio network (3) battery status reports from the mobile communication device (1), the battery status reports including at least an electrical battery parameter indicative of a current charge or voltage level of the battery (12); and
storing (S17) in the computerized service unit (2) battery data (222), based on the battery status reports received from the mobile communication device (1), the battery data (222) including at least a time series of the electrical battery parameter.

2. The method of claim 1, further comprising receiving (S12) in the computerized service unit (2) battery related event information included in the battery status reports from the mobile communication device (1), the battery related event information including at least one of: time when the battery was installed, time when battery recharging started, time when battery recharging completed, time when stand by mode was turned on, and time when stand by mode was turned off; and storing (S17) in the computerized service unit (2) battery data (222) including the battery related event information.

3. The method of one of claims 1 or 2, further comprising receiving (S12) in the computerized service unit (2) ambient temperature information associated with the battery (12) and included in the battery status reports from the mobile communication device (1); and storing (S17) in the computerized service unit (2) battery data (222) including the ambient temperature information associated with the battery (12).

4. The method of one of claims 1 to 3, further comprising determining (S18) in the computerized service unit (2), using the battery data (222), an expected value of a battery parameter; determining a deviation of a battery parameter, included in the battery status report, from the expected value of the battery parameter; and transmitting (S15b) a battery alarm signal from the computerized service unit (2) to one or more recipients (5), assigned in the computerized service unit (2) to the mobile communication device (1), for cases where the deviation exceeds a defined deviation threshold.

5. The method of one of claims 1 to 4, further comprising determining in the computerized service unit (2), using the battery data (222), an average recharging cycle time at the mobile communication device (1); and generating in the computerized service unit (2) a battery alarm signal for cases where the average recharging cycle time deviates from an expected value of the recharging cycle time.

6. The method of one of claims 1 to 5, further comprising determining in the computerized service unit (2), using the battery data (222), a threshold level for triggering in the mobile communication device (1) a low battery warning signal; and transmitting (S20) the threshold level from the computerized service unit (2) to the mobile communication device (1).

7. The method of one of claims 1 to 6, further comprising receiving (S25) in the computerized service unit (2) a low battery warning signal from the mobile communication device (1); and generating in the computerized service unit (2) a battery recharging alarm for cases where the battery is not recharged or replaced at the mobile communication device (1) within a defined time limit after the low battery warning signal.

8. A computerized service unit (2) comprising:
a communication module (24) configured to receive via a mobile radio network (3) periodic battery status reports from a mobile communication device (1), the battery status reports including at least an electrical battery parameter indicative of a current charge or voltage level of the battery (12); and
a battery analyzer (22) configured to store in the computerized service unit (2) battery data (222), based on the battery status reports received from the mobile communication device (1), the battery data (222) including at least a time series of the electrical battery parameter.

9. The computerized service unit (2) of claim 8, wherein the battery analyzer (22) is further configured to store in the computerized service unit (2) battery data (222) including battery related event information received in the battery status reports from the mobile communication device (1), the battery related event information including at least one of: time when the battery was installed, time when battery recharging started, time when battery recharging completed, time when stand by mode was turned on, and time when stand by mode was turned off.

10. The computerized service unit (2) of one of claims 8 or 9, wherein the battery analyzer (22) is further configured to store in the computerized service unit (2) battery data (222) including ambient temperature information associated with the battery (12) and received in the battery status reports from the mobile communication device (1).

11. The computerized service unit (2) of one of claims 8 to 10, wherein the battery analyzer (22) is further configured to determine, using the battery data (222), an expected value of a battery parameter, to determine a deviation of a battery parameter, included in the battery status report, from the expected value of the battery parameter, and to transmit a battery alarm signal to one or more recipients (5), assigned in the computerized service unit (2) to the mobile communication device (1), for cases where the deviation exceeds a defined deviation threshold.

12. The computerized service unit (2) of one of claims 8 to 11, wherein the battery analyzer (22) is further configured to determine, using the battery data (222), an average recharging cycle time at the mobile communication device (1), and to generate a battery alarm signal for cases where the average recharging cycle time deviates from an expected value of the recharging cycle time.

13. The computerized service unit (2) of one of claims 8 to 12, wherein the battery analyzer (22) is further configured to determine, using the battery data (222), a threshold level for triggering in the mobile communication device (1) a low battery warning signal, and to transmit the threshold level to the mobile communication device (1).

14. The computerized service unit (2) of one of claims 8 to 13, wherein the battery analyzer (22) is further configured to generate a battery recharging alarm for cases where the battery is not recharged or replaced at the mobile communication device (1) within a defined time limit after a low battery warning signal has been received in the computerized service unit (2) from the mobile communication device (1).

15. A battery powered mobile communication device (1) comprising a battery monitoring system (13) configured to monitor a battery status of the battery (12), the battery status including at least an electrical battery parameter indicative of a current charge or voltage level of the battery (12),
wherein the battery monitoring system (13) is further configured to generate and transmit battery status reports via a mobile radio network (3) to a computerized central service unit (2), the battery status reports including at least the electrical battery parameter, for generating and storing at the computerized central service unit (2) battery data (222) including at least a time series of the electrical battery parameter.

16. The mobile communication device (1) of claim 15, wherein the battery monitoring system (13) is further configured to transmit to the computerized service unit (2) battery related event information included in the battery status reports, the battery related event information including at least one of: time when the battery (12) was installed, time when battery recharging started, time when battery recharging completed, time when stand by mode was turned on, and time when stand by mode was turned off, for storing in the computerized service unit (2) battery data (222) including the battery related event information.

17. The mobile communication device (1) of one of claims 15 or 16, wherein the battery monitoring system (13) is further configured to measure and transmit to the computerized service unit (2) ambient temperature information associated with the battery (12) and included in the battery status reports, for storing in the computerized service unit (2) battery data (222) including the ambient temperature information associated with the battery (12).

18. The mobile communication device (1) of one of claims 15 to 17, wherein the mobile communication device (1) is a personal emergency call device (1), comprising an alarm module (11) configured to transmit to the computerized central service unit (2) via a mobile radio network (3) an alarm message on behalf of a user of the personal emergency call device (1).

## Patentansprüche

1. Verfahren zur Überwachung eines Batteriestatus einer Batterie (12), die in einer mobilen Kommunikationsvorrichtung (1) enthalten ist, wobei das Verfahren Folgendes umfasst:
Empfangen (S12) von Batteriestatusberichten von der mobilen Kommunikationsvorrichtung (1) in einer computerbasierten Serviceeinheit (2) über ein Mobilfunknetz (3), wobei die Batteriestatusberichte wenigstens einen elektrischen Batterieparameter umfassen, der eine Stromladung oder ein Spannungsniveau der Batterie (12) anzeigt; und
Speichern (S17) in der computerbasierten Serviceeinheit (2) von Batteriedaten (222), basierend auf den Batteriestatusberichten, die von der mobilen Kommunikationsvorrichtung (1) empfangen wurden, wobei die Batteriedaten (222) wenigstens eine Zeitreihe der elektrischen Batterieparameter enthalten.

2. Verfahren nach Anspruch 1, ferner umfassend Empfangen (S12) in der computerbasierten Serviceeinheit (2) von batteriebezogenen Ereignisinformationen, die in den Batteriestatusberichten von der mobilen Kommunikationsvorrichtung (1) enthalten sind, wobei die batteriebezogenen Ereignisinformationen wenigstens eines der Folgenden enthalten: Zeitpunkt, zu dem die Batterie eingesetzt wurde, Zeitpunkt, zu dem das Wiederaufladen der Batterie begann, Zeitpunkt, zu dem das Wiederaufladen der Batterie beendet wurde, Zeitpunkt, zu dem der Standby-Modus eingeschaltet wurde, und Zeitpunkt, zu dem der Standby-Modus abgeschaltet wurde; und Speichern (S17) in der computerbasierten Serviceeinheit (2) von Batteriedaten (222), die die batteriebezogenen Ereignisinformationen enthalten.

3. Verfahren nach einem der Ansprüche 1 oder 2, ferner umfassend Empfangen (S12) von Informationen zur Umgebungstemperatur, die mit der Batterie (12) zusammenhängen und in den Batteriestatusberichten von der mobilen Kommunikationsvorrichtung (1) enthalten sind, in der computerbasierten Serviceeinheit (2); und Speichern (S17) in der computerbasierten Serviceeinheit (2) von Batteriedaten (222), welche die Umgebungstemperaturinformationen, die mit der Batterie (12) zusammenhängen, enthalten.

4. Verfahren nach einem der Ansprüche 1 bis 3, ferner umfassend Bestimmen (S18) in der computerbasierten Serviceeinheit (2), unter Verwendung der Batteriedaten (222), eines erwarteten Wertes eines Batterieparameters; Bestimmen einer Abweichung eines Batterieparameters, der in dem Batteriestatusreport enthalten ist, von dem erwarteten Wert des Batterieparameters; und Übertragen (S15b) eines Batteriealarmsignals von der computerbasierten Serviceeinheit (2) an einen oder mehrere Empfänger (5), die in der computerbasierten Serviceeinheit (2) der mobilen Kommunikationsvorrichtung (1) zugeordnet sind, bei Fällen, in denen eine Abweichung eine bestimmte Abweichungsschwelle übersteigt.

5. Verfahren nach einem der Ansprüche 1 bis 4, ferner umfassend Bestimmen in der computerbasierten Serviceeinheit (2), unter Verwendung der Batteriedaten (222), einer durchschnittlichen Wiederaufladungszykluszeit bei der mobilen Kommunikationsvorrichtung (1); und Erzeugen in der computerbasierten Serviceeinheit (2) eines Batteriealarmsignals für Fälle, bei denen die durchschnittliche Wiederaufladungszykluszeit von einem erwarteten Wert der Wiederaufladungszykluszeit abweicht.

6. Verfahren nach einem der Ansprüche 1 bis 5, ferner umfassend Bestimmen in der computerbasierten Serviceeinheit (2), unter Verwendung der Batteriedaten (222), eines Schwellenniveaus zur Auslösung eines Warnsignals für niedrigen Batteriestatus in der mobilen Kommunikationsvorrichtung (1); und Übertragen (S20) des Schwellenniveaus von der computerbasierten Serviceeinheit (2) zur mobilen Kommunikationsvorrichtung (1).

7. Verfahren nach einem der Ansprüche 1 bis 6, ferner umfassend Empfangen (S25) in der computerbasierten Serviceeinheit (2) eines Warnsignals für niedrigen Batteriestatus von der mobilen Kommunikationsvorrichtung (1); und Erzeugen in der computerbasierten Serviceeinheit (2) eines Batteriewiederaufladealarms für Fälle, in denen die Batterie bei der mobilen Kommunikationsvorrichtung (1) nicht innerhalb eines bestimmten Zeitlimits nach dem Warnsignal für niedrigen Batteriestatus wieder aufgeladen oder ersetzt wurde.

8. Computerbasierte Serviceeinheit (2), umfassend:
ein Kommunikationsmodul (24), das konfiguriert ist, um über ein Mobilfunknetz (3) periodische Batteriestatusberichte von einer mobilen Kommunikationsvorrichtung (1) zu empfangen, wobei die Batteriestatusberichte wenigstens einen elektrischen Batterieparameter umfassen, der eine Stromladung oder ein Spannungsniveau der Batterie (12) anzeigt; und
eine Batterieanalysierungseinheit (22), die konfiguriert ist, Batteriedaten (222) in der computerbasierten Serviceeinheit (2) zu speichern, basierend auf den Batteriestatusberichten, die von der mobilen Kommunikationsvorrichtung (1) empfangen wurden, wobei die Batteriedaten (222) wenigstens eine Zeitreihe des elektrischen Batterieparameters enthalten.

9. Computerbasierte Serviceeinheit (2) nach Anspruch 8, wobei die Batterieanalysierungseinheit (22) ferner konfiguriert ist, in der computerbasierten Serviceeinheit (2) Batteriedaten (222) zu speichern, die batteriebezogene Ereignisinformationen enthalten, die in den Batteriestatusberichten von der mobilen Kommunikationsvorrichtung (1) empfangen wurden, wobei die batteriebezogenen Ereignisinformationen wenigstens eines der Folgenden umfassen: Zeitpunkt, zu dem die Batterie eingesetzt wurde, Zeitpunkt, zu dem das Wiederaufladen der Batterie begann, Zeitpunkt, zu dem das Wiederaufladen der Batterie beendet wurde, Zeitpunkt, zu dem der Standby-Modus eingeschaltet wurde, und Zeitpunkt, zu dem der Standby-Modus abgeschaltet wurde.

10. Computerbasierte Serviceeinheit (2) nach einem der Ansprüche 8 oder 9, wobei die Batterieanalysierungseinheit (22) ferner konfiguriert ist, Batteriedaten (222), welche Umgebungstemperaturinformationen enthalten, die mit der Batterie (12) zusammenhängen und in den Batteriestatusberichten von der mobilen Kommunikationsvorrichtung (1) empfangen wurden, in der computerbasierten Serviceeinheit (2) zu speichern.

11. Computerbasierte Serviceeinheit (2) nach einem der Ansprüche 8 bis 10, wobei die Batterieanalysiereinheit (22) ferner konfiguriert ist, unter Verwendung der Batteriedaten (222) einen erwarteten Wert eines Batterieparameters zu bestimmen, um eine Abweichung eines Batterieparameters, der in dem Batteriestatusbericht enthalten ist, von dem erwarteten Wert des Batterieparameters zu bestimmen, und ein Batteriealarmsignal an einen oder mehrere Empfänger (5) zu übertragen, die in der computerbasierten Serviceeinheit (2) der mobilen Kommunikationsvorrichtung (1) zugeordnet sind, bei Fällen, in denen die Abweichung eine definierte Abweichungsschwelle übersteigt.

12. Computerbasierte Serviceeinheit (2) nach einem der Ansprüche 8 bis 11, wobei die Batterieanalysiereinheit (22) ferner konfiguriert ist, unter Verwendung der Batteriedaten (222) eine durchschnittliche Wiederaufladzykluszeit bei der mobilen Kommunikationsvorrichtung (1) zu bestimmen, und ein Batteriealarmsignal für Fälle zu erzeugen, in denen die durchschnittliche Wiederaufladzykluszeit von einem erwarteten Wert der Wiederaufladzykluszeit abweicht.

13. Computerbasierte Serviceeinheit (2) nach einem der Ansprüche 8 bis 12, wobei die Batterieanalysiereinheit (22) ferner konfiguriert ist, unter Verwendung der Batteriedaten (222) ein Schwellenniveau zur Auslösung eines Warnsignals für niedrigen Batteriestatus in der mobilen Kommunikationsvorrichtung (1) zu bestimmen, und das Schwellenniveau an die mobile Kommunikationsvorrichtung (1) zu übertragen.

14. Computerbasierte Serviceeinheit (2) nach einem der Ansprüche 8 bis 13, wobei die Batterieanalysiereinheit (22) ferner konfiguriert ist, einen Batteriewiederaufladealarm zu erzeugen, für Fälle, in denen die Batterie bei der mobilen Kommunikationsvorrichtung (1) nicht innerhalb eines bestimmten Zeitlimits, nachdem das Warnsignal für niedrigen Batteriestatus in der computerbasierten Serviceeinheit (2) von der mobilen Kommunikationsvorrichtung (1) empfangen wurde, wieder aufgeladen oder ersetzt wurde.

15. Batteriebetriebene mobile Kommunikationsvorrichtung (1), umfassend ein Batterieüberwachungssystem (13), das konfiguriert ist, einen Batteriestatus der Batterie (12) zu überwachen, wobei der Batteriestatus wenigstens einen elektrischen Batterieparameter enthält, der eine Stromladung oder ein Spannungsniveau der Batterie (12) anzeigt,
wobei das Batterieüberwachungssystem (13) ferner konfiguriert ist, Batteriestatusberichte zu erzeugen und über ein Mobilfunknetz (3) an eine computerbasierte zentrale Serviceeinheit (2) zu übertragen, wobei die Batteriestatusberichte wenigstens den elektrischen Batterieparameter enthalten, zum Erzeugen und Speichern von Batteriedaten (222), die wenigstens eine Zeitreihe des elektrischen Batterieparameters enthalten, an der computerbasierten Serviceeinheit (2).

16. Mobile Kommunikationsvorrichtung (1) nach Anspruch 15, wobei das Batterieüberwachungssystem (13) ferner konfiguriert ist, batteriebezogene Ereignisinformationen, die in den Batteriestatusberichten enthalten sind, an die computerbasierte Serviceeinheit (2) zu übertragen, wobei die batteriebezogenen Ereignisinformationen wenigstens eines der Folgenden enthalten: Zeitpunkt, zu dem die Batterie (12) eingesetzt wurde, Zeitpunkt, zu dem das Wiederaufladen der Batterie begann, Zeitpunkt, zu dem das Wiederaufladen der Batterie beendet wurde, Zeitpunkt, zu dem der Standby-Modus eingeschaltet wurde, und Zeitpunkt, zu dem der Standby-Modus abgeschaltet wurde; zum Speichern von Batteriedaten (222), die die batteriebezogenen Ereignisinformationen enthalten, in der computerbasierten Serviceeinheit (2).

17. Mobile Kommunikationsvorrichtung (1) nach einem der Ansprüche 15 oder 16, wobei das Batterieüberwachungssystem (13) ferner konfiguriert ist, Umgebungstemperaturinformationen, die mit der Batterie (12) zusammenhängen und in den Batteriezustandsberichten enthalten sind, zu messen und an die computerbasierte Serviceeinheit (2) zu übertragen, zum Speichern von Batteriedaten (222), welche die Umgebungstemperaturinformationen im Zusammenhang mit der Batterie (12) enthalten, in der computerbasierten Serviceeinheit (2).

18. Mobile Kommunikationsvorrichtung (1) nach einem der Ansprüche 15 bis 17, wobei die mobile Kommunikationsvorrichtung (1) eine persönliche Notrufvorrichtung (1) ist, die ein Alarmmodul (11) umfasst, das konfiguriert ist, über ein Mobilfunknetz (3) eine Alarmbotschaft für einen Benutzer der persönlichen Notrufvorrichtung (1) an die computerbasierte zentrale Serviceeinheit (2) zu senden.

## Revendications

1. Procédé de contrôle d'un statut de batterie d'une batterie (12) comprise dans un dispositif de communication mobile (1), lequel procédé consiste à :
- recevoir (S12), dans une unité de service informatisée (2) via un réseau radio mobile (3), des rapports de statut de batterie depuis le dispositif de communication mobile (1), les rapports de statut de batterie comprenant au moins un paramètre de batterie électrique indiquant une charge de courant ou un niveau de tension de la batterie (12) ; et
- stocker (S17) dans l'unité de service informatisée (2) des données de batterie (222) en fonction des rapports de statut de batterie reçus du dispositif de communication mobile (1), les données de batterie (222) comprenant au moins une série temporelle du paramètre de batterie électrique.

2. Procédé selon la revendication 1, consistant en outre à recevoir (S12), dans l'unité de service informatisée (2), des informations d'événement concernant la batterie comprises dans les rapports de statut de batterie provenant du dispositif de communication mobile (1), les informations d'événement concernant la batterie comprenant l'un au moins parmi :
le moment où la batterie a été installée, le moment où le rechargement de la batterie a commencé, le moment où le rechargement de la batterie s'est terminé, le moment où le mode de veille a été activé, et le moment où le mode de veille a été désactivé ; et stocker (S17) dans l'unité de service informatisée (2) des données de batterie (222) comprenant les informations d'événement concernant la batterie.

3. Procédé selon l'une des revendications 1 ou 2, consistant en outre à recevoir (S12), dans l'unité de service informatisée (2), des informations de température ambiante associées à la batterie (12) et comprises dans les rapports de statut de batterie provenant du dispositif de communication mobile (1) ; et stocker (S17) dans l'unité de service informatisée (2) des données de batterie (222) comprenant les informations de température ambiante associées à la batterie (12).

4. Procédé selon l'une des revendications 1 à 3, consistant en outre à déterminer (S18), dans l'unité de service informatisée (2) et en utilisant les données de batterie (222), une valeur escomptée d'un paramètre de batterie ; déterminer un écart d'un paramètre de batterie compris dans le rapport de statut de batterie à partir de la valeur escomptée du paramètre de batterie ; et transmettre (S15b) un signal d'alarme de batterie depuis l'unité de service informatisée (2) vers un ou plusieurs destinataires (5) associés, dans l'unité de service informatisée (2), au dispositif de communication mobile (1) dans les cas où l'écart dépasse un seuil d'écart déterminé.

5. Procédé selon l'une des revendications 1 à 4, consistant en outre à déterminer, dans l'unité de service informatisée (2) et en utilisant les données de batterie (222), un temps de cycle de rechargement moyen au niveau du dispositif de communication mobile (1) ; et générer dans l'unité de service informatisée (2) un signal d'alarme de batterie dans les cas où le temps de cycle de rechargement moyen s'écarte d'une valeur escomptée du temps de cycle de rechargement.

6. Procédé selon l'une des revendications 1 à 5, consistant en outre à déterminer, dans l'unité de service informatisée (2) et en utilisant les données de batterie (222), un niveau seuil pour déclencher, dans le dispositif de communication mobile (1), un signal d'avertissement de batterie faible ; et transmettre (S20) le niveau seuil depuis l'unité de service informatisée (2) vers le dispositif de communication mobile (1).

7. Procédé selon l'une des revendications 1 à 6, consistant en outre à recevoir (S25) dans l'unité de service informatisée (2) un signal d'avertissement de batterie faible depuis le dispositif de communication mobile (1) ; et générer dans l'unité de service informatisée (2) une alarme de rechargement de batterie dans les cas où la batterie n'est pas rechargée ou remplacée au niveau du dispositif de communication mobile (1) dans une limite de temps définie après le signal d'avertissement de batterie faible.

8. Unité de service informatisée (2) comprenant :
- un module de communication (24) conçu pour recevoir, via un réseau radio mobile (3), des rapports de statut de batterie périodiques depuis un dispositif de communication mobile (1), les rapports de statut de batterie comprenant au moins un paramètre de batterie électrique indiquant une charge de courant ou un niveau de tension de la batterie (12) ; et
- un analyseur de batterie (22) conçu pour stocker dans l'unité de service informatisée (2) des données de batterie (222) en fonction des rapports de statut de batterie reçus depuis le dispositif de communication mobile (1), les données de batterie (222) comprenant au moins une série temporelle du paramètre de batterie électrique.

9. Unité de service informatisée (2) selon la revendication 8, dans laquelle l'analyseur de batterie (22) est en outre conçu pour stocker, dans l'unité de service informatisée (2), des données de batterie (222) comprenant des informations d'événement concernant la batterie reçues dans les rapports de statut de batterie provenant du dispositif de communication mobile (1), les informations d'événement concernant la batterie comprenant l'un au moins parmi : le moment où la batterie a été installée, le moment où le rechargement de la batterie a commencé, le moment où le rechargement de la batterie s'est terminé, le moment où le mode de veille a été activé, et le moment où le mode de veille a été désactivé.

10. Unité de service informatisée (2) selon l'une des revendications 8 ou 9, dans laquelle l'analyseur de batterie (22) est en outre conçu pour stocker, dans l'unité de service informatisée (2), des données de batterie (222) comprenant des informations de température ambiante associées à la batterie (12) et reçues dans les rapports de statut de batterie provenant du dispositif de communication mobile (1).

11. Unité de service informatisée (2) selon l'une des revendications 8 à 10, dans laquelle l'analyseur de batterie (22) est en outre conçu pour déterminer, en utilisant les données de batterie (222), une valeur escomptée d'un paramètre de batterie, déterminer un écart d'un paramètre de batterie compris dans le rapport de statut de batterie à partir de la valeur escomptée du paramètre de batterie, et transmettre un signal d'alarme de batterie vers un ou plusieurs destinataires (5) associés, dans l'unité de service informatisée (2), au dispositif de communication mobile (1) dans les cas où l'écart dépasse un seuil d'écart déterminé.

12. Unité de service informatisée (2) selon l'une des revendications 8 à 11, dans laquelle l'analyseur de batterie (22) est en outre conçu pour déterminer, en utilisant les données de batterie (222), un temps de cycle de rechargement moyen au niveau du dispositif de communication mobile (1), et générer un signal d'alarme de batterie dans les cas où le temps de cycle de rechargement moyen s'écarte d'une valeur escomptée du temps de cycle de rechargement.

13. Unité de service informatisée (2) selon l'une des revendications 8 à 12, dans laquelle l'analyseur de batterie (22) est en outre conçu pour déterminer, en utilisant les données de batterie (222), un niveau seuil pour déclencher, dans le dispositif de communication mobile (1), un signal d'avertissement de batterie faible, et transmettre le niveau seuil vers le dispositif de communication mobile (1).

14. Unité de service informatisée (2) selon l'une des revendications 8 à 13, dans laquelle l'analyseur de batterie (22) est en outre conçu pour générer une alarme de rechargement de batterie dans les cas où la batterie n'est pas rechargée ou remplacée au niveau du dispositif de communication mobile (1) dans une limite de temps définie après qu'un signal d'avertissement de batterie faible a été reçu dans l'unité de service informatisée (2) depuis le dispositif de communication mobile (1).

15. Dispositif de communication mobile (1) alimenté par batterie, comprenant un système de contrôle de batterie (13) conçu pour contrôler un statut de batterie de la batterie (12), le statut de batterie comprenant au moins un paramètre de batterie électrique indiquant une charge de courant ou un niveau de tension de la batterie (12),
dans lequel le système de contrôle de batterie (13) est en outre conçu pour générer et transmettre des rapports de statut de batterie via un réseau radio mobile (3) vers une unité de service centrale informatisée (2), les rapports de statut de batterie comprenant au moins le paramètre de batterie électrique, afin de générer et de stocker au niveau de l'unité de service centrale informatisée (2) des données de batterie (222) comprenant au moins une série temporelle du paramètre de batterie électrique.

16. Dispositif de communication mobile (1) selon la revendication 15, dans lequel le système de contrôle de batterie (13) est en outre conçu pour transmettre à l'unité de service informatisée (2) des informations d'événement concernant la batterie comprises dans les rapports de statut de batterie, les informations d'événement concernant la batterie comprenant l'un au moins parmi : le moment où la batterie (12) a été installée, le moment où le rechargement de la batterie a commencé, le moment où le rechargement de la batterie s'est terminé, le moment où le mode de veille a été activé, et le moment où le mode de veille a été désactivé ; afin de stocker dans l'unité de service informatisée (2) des données de batterie (222) comprenant les informations d'événement concernant la batterie.

17. Dispositif de communication mobile (1) selon l'une des revendications 15 ou 16, dans lequel le système de contrôle de batterie (13) est en outre conçu pour mesurer et transmettre à l'unité de service informatisée (2) des informations de température ambiante associées à la batterie (12) et comprises dans les rapports de statut de batterie, afin de stocker dans l'unité de service informatisée (2) des données de batterie (222) comprenant les informations de température ambiante associées à la batterie (12).

18. Dispositif de communication mobile (1) selon l'une des revendications 15 à 17, lequel dispositif de communication mobile (1) est un dispositif d'appel d'urgence personnel (1) comprenant un module d'alarme (11) conçu pour transmettre à l'unité de service centrale informatisée (2), via un réseau radio mobile (3), un message d'alarme de la part d'un utilisateur du dispositif d'appel d'urgence personnel (1).
